# EUROPEAN PATENT APPLICATION

(11) **EP 4 610 678 A1**
(43) Date of publication of application: **03.09.2025**
(21) Application number: 25158440.5
(22) Date of filing: 17.02.2025
(51) Int. Cl.: G01R 31/36, G01R 31/3835, G01R 31/392, G01R 19/165

(54) **APPARATUS FOR DETERMINING VEHICLE BATTERY STATE**

(30) Priority: 27.02.2024 AU 2024201286
(71) Applicant: Shenzhen Prime Logic Technology Co., Ltd., 518128 Shenzhen City, Guangdong (CN)
(72) Inventor: NG, Cleo Man Oi, Bao an Shenzhen City, 518128 (CN)
(74) Representative: Cabinet Chaillot

(57) **Abstract**

The present invention provides an apparatus for determining the state of a rechargeable battery (15) used to power a starter motor (20) of an engine. The apparatus comprises: a voltage measurement means (25) configured to measure a voltage in a rechargeable battery (15) of an engine starting circuit configured to power the starter motor (20), a voltage relation means in operable connection with the voltage detector (15), and a user comprehensible output means (40). The apparatus is configured such that during powering of the starter motor (20) the voltage measurement means (25) measures one or more voltage values of the rechargeable battery (15), and the voltage relation means relates the measured one or more voltage values to a predetermined one or more voltage values so as to determine a state of the rechargeable battery (15). The user comprehensible output (40) is configured to output an indication of the state of the rechargeable battery (15).

## Description

### FIELD OF THE INVENTION

The present invention relates to the field of testing rechargeable batteries used to start an electrically cranked engine such as an automobile engine.

### BACKGROUND TO THE INVENTION

Many types of engine are cranked with an electric starter motor. Particularly in vehicles and other forms of transport the starter motor is powered by an on-board battery. Once the engine has started, a generator coupled to the engine typically recharges the battery so as to be ready for the next start. This arrangement is often incorporated into automobiles, boats, motorcycles, portable power generators and the like.

As is well known, all rechargeable batteries have a finite life beyond which the battery cannot be sufficiently charged (or cannot hold charge for a sufficient time) so as to provide the required electrical current to the starter motor for proper cranking of the engine. In modern automobiles in particular, the battery is exposed to a considerable parasitic load due to the heavy use of accessories such as stereo amplifiers, navigation systems, video displays and the like.

In many instances, automobile drivers may not appreciate the early signs of impending battery failure (such as slow cranking) and fail to replace the battery in good time. Typically a driver will crank the engine for longer than usual or execute multiple starting attempts, with these activities further exacerbating the already poor state of the battery. Eventually, the battery is depleted to the point that the engine cannot be started.

A driver's assessment of a battery state may be confounded by the ambient temperature. In colder conditions a driver may expect slower engine cranking, and therefore slower starting. Thus, slow cranking may be not be attributed to any deficiency in the battery *per se,* and an incorrect assumption made that the battery is not in any uncompromised state.

In any event, it is possible that an automobile driver may not be provided with any sign or symptom to suggest that vehicle battery may be in a compromised state.

In light of the above, it is not uncommon for a driver to be stranded due to failure of the vehicle battery to crank and start the vehicle engine. In such circumstances, the driver must call for a roadside assistance service to "jump start" the engine, and then to arrange the battery to be replaced at a service center. Of course, this results in considerable cost and inconvenience to the driver.

The prior art provides apparatus which provide information on a vehicle battery, however problems of inaccuracy, cost and complexity arise. Some prior art apparatus drain significant power from the vehicle electrical circuit which of itself may lead to starting problems.

It is an aspect of the present invention to overcome or alleviate a problem of the prior art, or to provide a useful alternative to the prior art.

The discussion of documents, acts, materials, devices, articles and the like is included in this specification solely for the purpose of providing a context for the present invention. It is not suggested or represented that any or all of these matters formed part of the prior art base or were common general knowledge in the field relevant to the present invention as it existed before the priority date of each claim of this application.

### SUMMARY OF THE INVENTION

In a first aspect, but not necessarily the broadest aspect, the present invention provides an apparatus for determining the state of a rechargeable battery used to power a starter motor of an engine, the apparatus comprising:
a voltage measurement means configured to measure a voltage value in a rechargeable battery of an engine starting circuit configured to power the starter motor,
a voltage relation means in operable connection with the voltage detector,
a user comprehensible output means,
wherein the apparatus is configured such that during powering of the starter motor the voltage measurement means measures one or more voltage values of the rechargeable battery, and the voltage relation means relates the measured one or more voltage values to a predetermined one or more voltage values so as to determine a state of the rechargeable battery, and the user comprehensible output is configured to output an indication of the state of the rechargeable battery.

In one embodiment of the first aspect, the voltage relation means comprises an analogue circuit and/or a microprocessor.

In one embodiment of the first aspect, the relating of voltage values comprises comparing voltage values or comparing rates of change in voltage values.

In one embodiment of the first aspect, two or more voltage values are measured, and the voltage relation means is configured to compare a low voltage value, or the lowest voltage value, of the measured two or more voltage values to the predetermined one or more voltage values.

In one embodiment of the first aspect, where the low voltage value or the lowest voltage is determined by the voltage relation means to be less than the predetermined one or more voltage values, the user comprehensible output outputs a warning indicating that the rechargeable battery is in a compromised state.

In one embodiment of the first aspect, the predetermined voltage value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the voltage specification of the rechargeable battery.

In one embodiment of the first aspect, the predetermined voltage value is equal to or less than about 10V, 9.9V, 9.8V, 9.7V, 9.6V, 9.5V, 9.4V, 9.3V, 9.2V, 9.1V, 9.0V, 8.9V, 8.7V, 8.6V. 8.5V, 8.4V, 8.3V, 8.2V, 8.1V, or 8.0V.

In one embodiment of the first aspect, the predetermined voltage value is equal to or less than about 9.0V.

In one embodiment of the first aspect, where the rate of change in voltage values is determined by the voltage relation means to be greater than a predetermined rate, the user comprehensible output outputs a warning indicating that the rechargeable battery is in a compromised state.

In one embodiment of the first aspect, the predetermined rate of change in voltages value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the rate specification of the rechargeable battery when new.

In one embodiment of the first aspect, the apparatus comprises a temperature measuring means, and the apparatus is configured to utilise a measured temperature value to determine a state of the rechargeable battery.

In one embodiment of the first aspect, the temperature measuring means measures the temperature of: a part of the rechargeable battery, an object about the rechargeable battery, or the environs about the rechargeable battery, a part of the starter motor, an object about the starter motor, or the environs about the starter motor, or within an enclosed area holding the rechargeable battery and/or the starter motor, or an ambient temperature, or an engine air intake temperature.

In one embodiment of the first aspect, the measured temperature value is used to calculate, interpolate, extrapolate, select, generate, modify or otherwise provide the predetermined one or more voltage values.

In one embodiment of the first aspect, the measured one or more voltage values and optionally the measured temperature value is/are used by the microprocessor to determine whether or not to instruct the user comprehensible output unit to output a warning that the rechargeable battery is in a compromised state.

In one embodiment of the first aspect, the voltage measuring means is a connection configured to connect to the OBD system of a vehicle comprising the rechargeable battery.

In one embodiment of the first aspect, the voltage measuring means is, or comprises a volt meter of a vehicle comprising the rechargeable battery.

In one embodiment of the first aspect, the voltage measuring means is a volt meter existing as original equipment connected to the rechargeable battery.

In one embodiment of the first aspect, the voltage measuring means is a volt meter dedicated to operation of the apparatus.

In one embodiment of the first aspect, the temperature measuring means is a thermocouple or a thermistor.

In one embodiment of the first aspect, the apparatus is configured to connect to a vehicle OBD system.

In one embodiment of the first aspect, the apparatus is configured to connect to a vehicle OBD connector.

In one embodiment of the first aspect, the apparatus is configured to replace a vehicle OBD connector.

In one embodiment of the first aspect, the voltage relation means is a microprocessor comprising or having access to electronic memory having stored thereon program instructions configured to perform any one or more of the following:
sampling one or more voltages output by the voltage measurement unit,
sampling or more temperatures output by the temperature measurement unit,
relating a predetermined voltage to sampled one or more voltages,
comparing a predetermined voltage to sampled one or more voltages.

In one embodiment of the first aspect, the apparatus is constructed by way of a modular PCB design methodology.

In one embodiment of the first aspect, the engine is an internal combustion engine.

In one embodiment of the first aspect, the engine is used to power a water vehicle, a land vehicle, an air vehicle, an item of machinery, or an electricity generator.

In one embodiment of the first aspect, the land vehicle is an automobile, a motorcycle, a recreation vehicle, a commercial vehicle, or a truck.

In a second aspect, the present invention provides a method of determining the state of a rechargeable battery used to power a starter motor of an engine, the method comprising: during powering of the starter motor measuring one or more voltage values of the rechargeable battery, and relating the measured one or more voltage values to a predetermined one or more voltage values so as to determine a state of the rechargeable battery, and outputting a user comprehensible output indicating the state of the rechargeable battery.

In one embodiment of the second aspect, two or more voltage values are measured, and the voltage relation compares a low voltage value, or the lowest voltage value, of the measured two or more voltage values to the predetermined one or more voltage values.

In one embodiment of the second aspect, where the low voltage value or the lowest voltage is less than the predetermined one or more voltage values, the user comprehensible output outputs a warning indicating that the rechargeable battery is in a compromised state.

In one embodiment of the second aspect, the predetermined voltage value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the voltage specification of the rechargeable battery.

In one embodiment of the second aspect, the predetermined voltage value is equal to or less than about 10V, 9.9V, 9.8V, 9.7V, 9.6V, 9.5V, 9.4V, 9.3V, 9.2V, 9.1V, 9.0V, 8.9V, 8.7V, 8.6V. 8.5V, 8.4V, 8.3V, 8.2V, 8.1V, or 8.0V.

In one embodiment of the second aspect, the predetermined voltage value is equal to or less than about 9.0V.

In one embodiment of the second aspect, where a rate of change in voltage values is greater than a predetermined rate, the user comprehensible output outputs a warning indicating that the rechargeable battery is in a compromised state.

In one embodiment of the second aspect, the predetermined rate of change in voltages value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the rate specification of the rechargeable battery when new.

In one embodiment of the second aspect, the method comprises measuring a temperature value.

In one embodiment of the second aspect, the temperature of: a part of the rechargeable battery, an object about the rechargeable battery, or the environs about the rechargeable battery, a part of the starter motor, an object about the starter motor, or the environs about the starter motor, or within an enclosed area holding the rechargeable battery and/or the starter motor, or an ambient temperature, or an engine air intake temperature is measured.

In one embodiment of the second aspect, the method comprises utilising the measured temperature value is used to calculate, interpolate, extrapolate, select, generate, modify or otherwise provide the predetermined one or more voltage values.

In one embodiment of the second aspect, the method comprises utilising the measured one or more voltage values and optionally the measured temperature value to determine whether or not to output a warning that the rechargeable battery is in a compromised state.

### BRIEF DESCRIPTION OF THE DRAWINGS

FIG. 1A is a graph of battery voltage as a function of time, including during the period of engine starting. This graphs represents a serviceable battery.
FIG. 1B is a graph of battery voltage as a function of time, including during the period of engine starting. This graphs represents a compromised battery that should be replaced.
FIG. 2 is a block diagram of a preferred embodiment of the present apparatus that utilizes battery voltage and temperature information to determine the state of a rechargeable battery.
FIG. 3 is a block diagram of an embodiment similar to that shown in FIG. 2, although configured to utilize battery voltage provided by a vehicle's OBD system.
FIG. 4 is a schematic diagram of a highly preferred embodiment of the invention.

### DETAILED DESCRIPTION OF THE INVENTION

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects may lie in less than all features of a single foregoing disclosed embodiment. Thus, the claims following the Detailed Description are hereby expressly incorporated into this Detailed Description, with each claim standing on its own as a separate embodiment of this invention.

Furthermore, while some embodiments described herein include some but not other features included in other embodiments, combinations of features of different embodiments are meant to be within the scope of the invention, and from different embodiments, as would be understood by those in the art.

In the claims below and the description herein, any one of the terms "comprising", "comprised of" or "which comprises" is an open term that means including at least the elements/features that follow, but not excluding others. Thus, the term comprising, when used in the claims, should not be interpreted as being limitative to the means or elements or steps listed thereafter. For example, the scope of the expression a method comprising step A and step B should not be limited to methods consisting only of methods A and B. Any one of the terms "including" or "which includes" or "that includes" as used herein is also an open term that also means including at least the elements/features that follow the term, but not excluding others. Thus, "including" is synonymous with and means "comprising".

The present invention is predicated at least in part on the finding that the serviceability of a rechargeable battery in an engine starting circuit can be assessed by a consideration of the voltage drop that occurs in the circuit while starting the engine. Even when a battery is new, a measurable voltage drop occurs during engine starting.

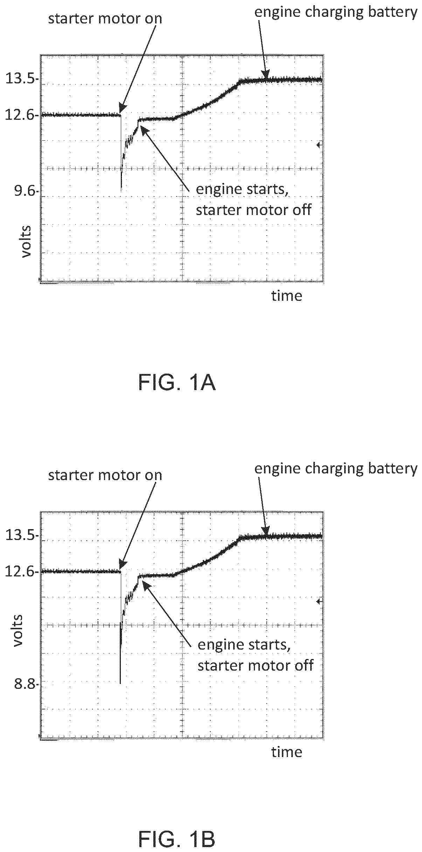

Reference is made to FIG. 1A showing the voltage drop observed in a serviceable automobile lead acid battery during engine starting. The battery has a voltage of 12.6V before the engine has been started. Upon actuation of the starter motor, voltage rapidly drops to 9.6V. Once the engine starts, the starter motor is off, and the electrical power generator driven by the engine outputs 13.5V to charge the battery. In this instance, the lowest voltage measured (9.6V) which is over 9.0V, indicating that the battery is serviceable and does not require replacement.

When a battery has become compromised over repeated charge and discharge cycles the voltage drop increases. Referring now to FIG. 1B, there is shown the voltage drop of an exemplary lead acid battery that is compromised and requires replacement. In this instance, the battery exhibits a normal (12.6V) voltage at rest, however when placed under load by the starter motor the voltage drops significantly to 8.8V, which is below the exemplary threshold level of 9.0 V. This result indicates replacement of the battery to avoid engine starting problems or starting failure at a later time.

As will be appreciated, the voltage threshold may vary according to a number of factors, including any one or more of battery capacity (in Ah), the normal voltage of an uncompromised battery, the engine start time, the brand of vehicle, the model of vehicle, the age of vehicle. Some embodiments of the apparatus will therefore allow for some customization or selection of a suitable threshold voltage according to any one or more of the aforementioned factors. For example, a multiple-position switch, or a variable resistor may be used to select a suitable threshold voltage. A suitable voltage may be selected by reference to a table provided to the user with the apparatus. In other embodiments, the apparatus is configured to use threshold as determined under starting of the vehicle with a known good battery. For example, the apparatus may measure the lowest voltage, and then set a threshold value at, say, a voltage that is 10% lower.

More sophisticated approaches may be implemented. For example, the lowest voltage during engine starting can be measured (say, the lowest voltage value in the 0-100 ms period), and then the average voltage value during a later time period (say, 101-300 ms) and use the difference in those voltage values to set a threshold voltage. As a further alternative, an average voltage value across the entire engine starting period (say, 0-300 ms) may be used as a threshold value.

As an alternative to a consideration of voltage drop, serviceability of the battery may be discernible by reference to a rate of voltage drop during engine starting. Any rate that varies appreciably from the rate seen in a new battery may indicate sufficient compromise in output during engine starting so as to justify replacement. For example, a relatively high rate of voltage drop may indicate that the battery should be replaced.

The apparatus may measure voltage in the engine starting circuit by any suitable means. In one embodiment, the apparatus disposes a volt meter across with the battery terminals. A suitable connection may be effected between the positive terminal of the battery and a ground. The apparatus may be configured to sample voltage values from the volt meter during engine starting. The apparatus may obtain electrical power for operation by way of the rechargeable battery, a dedicated battery, or by some other means.

As an alternative, a voltage reading may be taken by the apparatus from an On-Board Diagnostics (OBD) system of the type often present in a vehicle. Thus, the apparatus connects to the OBD system and samples voltage values during engine starting. Conveniently the OBD system may provide electrical power (for example, via OBD2 pin 16) for operation of the apparatus.

In OBD-reliant embodiments, the apparatus comprises a microprocessor configured to read a voltage value output by the OBD system.

In some embodiments, the apparatus is configured to connect to a standard OBD connection port (such as a 16 pin OBD2 connector). In such embodiments, the apparatus may be removable from the connector to allow for a diagnostic computer to be connected as required. In other embodiments, the apparatus has a "pass through" configuration allowing for substantially permanent installation whilst providing also an OBD connection port allowing for the use of a diagnostic computer whilst the apparatus remains connected.

In some embodiments, the apparatus replaces a vehicle's OBD connector, or is otherwise substantially permanently connected to the OBD connector. These embodiments may be most conveniently installed by the vehicle manufacturer during production. Retrofitting may nevertheless be performed.

The apparatus comprises suitable means for relating a voltage measured by the voltage measuring means to determine a battery state by reference to a predetermined voltage. Staying with the example used above, the apparatus comprises means for comparing a voltage drop during engine starting to a predetermined voltage value (9.0V). Some means of comparing the lowest voltage measured during starting to 9.0V is required. Such means may be wholly analogue, an example of which is an op-amp comparator. An op-amp comparator compares one analogue voltage level with another analogue voltage level, or some preset reference voltage, V_{REF} (such as 9.0V) and produces an output signal based on this voltage comparison. Expressed differently, the op-amp voltage comparator compares the magnitudes of two voltage inputs and determines which is the largest of the two. A voltage comparators may use either positive feedback or no feedback at all (open-loop mode) to switch its output between two saturated states, because in the open-loop mode the amplifiers voltage gain is basically equal to A_{VO}. Due to this high open loop gain, the output from the comparator swings either fully to its positive supply rail, +Vcc or fully to its negative supply rail, -Vcc on the application of varying input signal which passes some preset threshold value. An open-loop op-amp comparator is an analogue circuit that operates in its non-linear region as changes in the two analogue inputs, V+ and V- causes it to behave like a digital bistable device as triggering causes it to have two possible output states, +Vcc or -Vcc. In that sense the voltage comparator is essentially a 1-bit analogue to digital converter, as the input signal is analogue but the output behaves digitally. A compromised battery is indicated where the voltage measured falls below 9.0V during engine starting, and in which case the op-amp produces an output that in turn triggers an alert output that is comprehensible by the vehicle operator.

In other embodiments, the means for voltage comparison is wholly digital and is provided by a microprocessor. Voltage of the engine starting circuit is applied to a relevant microprocessor input pin and assessed by program instructions stored in electronic memory. The program instructions may store the predetermined voltage (9.0V in the example), and compare the voltage applied to the input pin to the predetermined voltage. A compromised battery is indicated where the voltage measured falls below 9.0V during engine starting, and in which case the program instructions triggers an alert output that is comprehensible by the vehicle operator.

In other embodiments, hybrid analogue/digital means are used to compare voltage. An example is where an op-amp output connects to the input pin of a microprocessor.

It has been further found that a consideration of temperature can assist in the assessment of serviceability of a rechargeable battery in an engine starting circuit. Under cold conditions, voltage may drop more rapidly and/or to a lower voltage as compared with engine starting under milder conditions. Thus, under mild temperatures the apparatus may set a voltage drop to 9.0V as a predetermined threshold voltage value under which the battery is considered compromised. However, under colder conditions the predetermined threshold voltage value may be lowered to, say, 8.6V to take account of the inherently greater voltage drop that would occur even in a new battery during engine starting. Furthermore, a starter motor may be more difficult to turn in colder conditions there increasing the power draw on the battery. These embodiments of the apparatus lessen the possibility that a serviceable battery is not prematurely and unnecessarily replaced.

Conversely, under higher temperature conditions the predetermined threshold voltage value may be increased to, say, 9.4V to take account of the inherently lower voltage drop that may occur in a new battery during engine starting. Rechargeable batteries tend to deliver power more readily at higher temperatures. Furthermore, a starter motor may experience less frictional forces and be easier to turn in warmer conditions there decreasing the power draw on the battery. These embodiments of the apparatus decrease the possibility that a battery is incorrectly assessed as serviceable, when it is in fact compromised and due for replacement.

Temperature is most effectively measured on or about the rechargeable battery, or on or about the starter motor. The temperature at these positions is most relevant because it is informative of the relative difficulty or ease by which the rechargeable battery is able to turn the starter motor. Conveniently, temperature may be obtained be obtained from the OBD system of a vehicle that may return engine coolant temperature or air intake temperature or ambient temperature.

As is understood by the skilled person, temperature may be measured by way of a thermocouple or a thermistor.

Embodiments of the apparatus utilizing temperature input will typically comprise a microprocessor. Output of a thermocouple or thermistor, for example, may be connected to a relevant input pin of the microprocessor.

Program instructions executed by the microprocessor utilize both measured voltage and measured temperature in determining (typically by algorithmic means) where or not the rechargeable battery is serviceable, or is compromised and require replacement.

For example, the program instructions may define a series of predetermined voltages each of which is applicable at a certain temperature. An electronic lookup table may be provided for the purpose, as exemplified below.

| Temperature (degrees Celsius) | Predetermined Voltage Threshold (V) |
|---|---|
| ≤0 | 8.8 |
| >0 to <10 | 8.9 |
| ≥ 10 to <20 | 9.0 |
| ≥ 20 to <30 | 9.1 |
| ≥ 10 to <20 | 9.2 |

Various alternatives are contemplated to the use of temperature in determining the most suitable predetermined voltage for the conditions. A calculation may be implemented by the processor, so as to, for example, increase the predetermined voltage by 0.1V for each degree temperature increase, starting from a basic value of 8.0 V at -20 degrees Celsius. Other transformations of voltage based on temperature may be implemented, as considered suitable by the skilled person.

The present apparatus provides a user comprehensible output means to indicate that the rechargeable battery is compromised and requires replacement. The output may be triggered by an analogue signal output (such as that effected by the op-amp embodiment of a voltage comparator described *supra*) or by a digital output (such as that effected by the microprocessor embodiment of a voltage comparator described *supra*). The output means may be digital (such as an LCD display) and may accept analogue or digital input. The output means may be analogue (such as a buzzer) and may accept analogue or digital input.

The output means may alert the user by visual means (for example, an LCD display showing relevant text, or an alert light), or audible means (for example, a buzzer, or a voice synthesizer speaking relevant words).

The output means may be incorporated into a vehicle instrument cluster, or otherwise disposed within a vehicle cabin. When an audible alert is given, the output means may be located in hidden space such as under a dash or a seat.

As will be noted from the description above, the apparatus may be substantially self-contained with all necessary components provided. Alternatively, some components may be provided by a vehicle or other machinery having the rechargeable battery and starter motor. As an example, a volt meter already existing within a vehicle and accessible by the OBD system may form part of the apparatus.

In some embodiments, the apparatus is configured so as to draw only limited amounts of current. Where power is supplied by a vehicle battery, a low current draw apparatus decreases parasitic current draw thereby helping to extend the life of the vehicle battery. Where power is supplied by a battery dedicated to the apparatus, battery life is extended by a low current draw apparatus.

Preferably, the apparatus is configured to draw less than about 0.5 mA, 0.4 mA, 0.3 mA, 0.2 mA or 0.1 mA.

Low current draw embodiments may comprise program instructions configured to place the apparatus into "sleep" mode whereby power dissipation circuitry is isolated from the power source. The apparatus may be normally in sleep mode, and transitions into "awake" mode upon detection of a drop in voltage associated with vehicle ignition active, or cranking of the starter motor. One the engine has started, as detected by an increase in voltage or by some other means, the apparatus is returned to sleep mode by program instructions.

As a further alternative, a vibration sensor in the apparatus may detect when a person enters a vehicle, such detection triggering transition from sleep mode to awake mode.

The present invention will now be more fully described by reference to the following preferred embodiments.

### PREFERRED EMBODIMENTS OF THE INVENTION

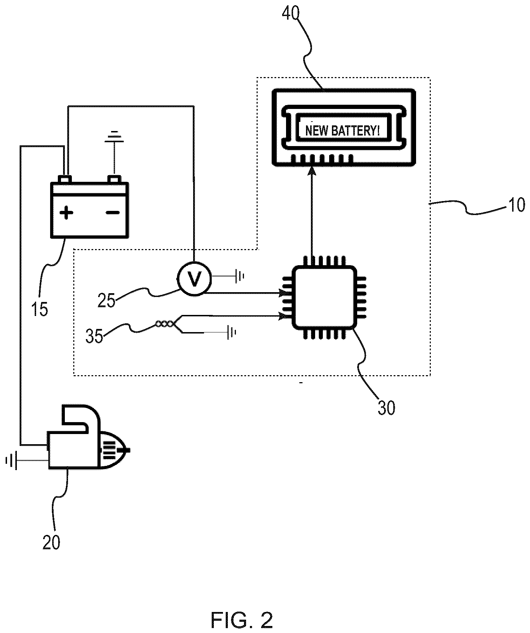

FIG. 2 shows a preferred apparatus (10) of the present invention that utilizes voltage input and temperature to determine the serviceability of rechargeable battery (15). This embodiment may be applicable to an automotive installation. The rechargeable battery (15) power an electrical starter motor (20) which turns the engine flywheel (not shown) during engine starting.

A voltage measuring device (25) measures voltage value of the rechargeable battery (15) during engine starting as shown in FIG. 1A. The output signal of the voltage measuring device (25) is sent to an input pin of microprocessor (30) for processing.

The apparatus further comprises a thermocouple (35) for detecting the temperature in the engine bay of the automobile and proximal to the rechargeable battery (15) or starter motor (20). The output signal of the thermocouple (35) is sent to an input pin of microprocessor (30) for processing.

The microprocessor (30) has access to program instructions stored in electronic memory (not drawn) configured to select a threshold voltage value from a range of possible stored values in accordance with the temperature measurement reported by the thermocouple (35). An electronic lookup table as disclosed *supra* may be used for that purpose.

Upon selection of the threshold voltage value, the program instructions sample voltages during actuation of the starter motor (20) during engine starting. The lowest voltage is identified, and compared to the selected threshold voltage value.

Where the lowest voltage is less than the selected threshold voltage value, the processor instructs LCD (40) to output text "NEW BATTERY!" to warn that the rechargeable battery (15) is compromised and should be replaced.

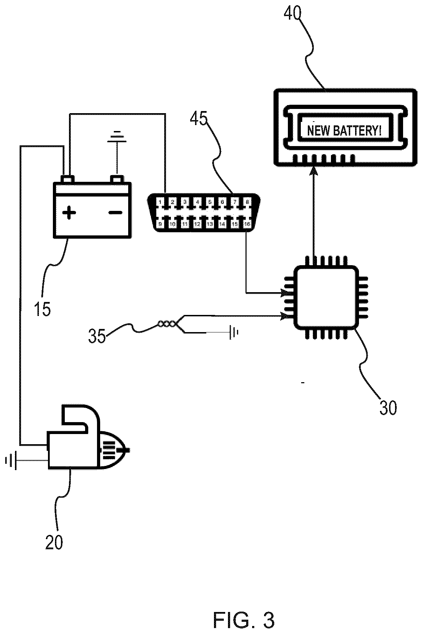

An apparatus of the present invention that connects to a vehicle OBD2 port (45) is shown at FIG. 3. The operation is generally the same to that as for the embodiment of FIG. 2. In the embodiment of FIG. 3, pin 16 of the OBD2 port (45) is connected to the voltage input pin of microprocessor (30). Pin 16 continuously outputs voltage of the rechargeable battery (15), and the voltage may be sampled under direction of the program instructions accessible by the microprocessor (30).

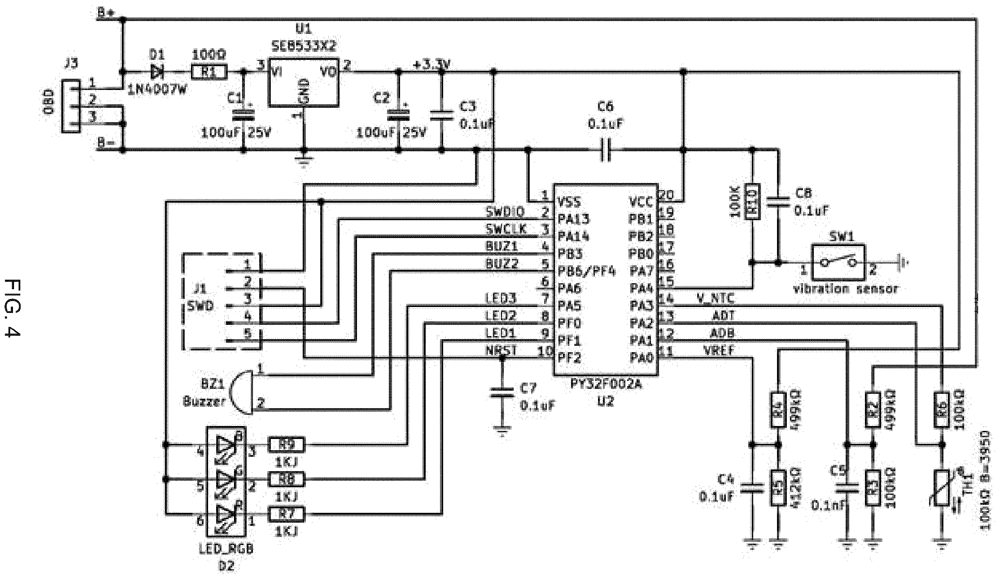

Reference is now made FIG. 4, being a schematic for a highly preferred embodiment of the invention. The OBD connector is connected to the battery terminals (B+ and B-).

3.3V power source supplies to U2 MCU chip by LDO U1 from battery; R1 is a current limited resistor to prevent the surge to U1; C1, C2, C3 and C6 are filter capacitors to provide clean power at 3.3V.

R2, R3 and C5 constitutes the voltage sampling circuitry, R2 and R3 consists of the voltage divider, with the collected battery voltage being then sent to ADB pin 12 of MCU, the collected voltage is compared to the MCU internal reference basic voltage, then driving the buzzer or LED operation via comparing the preset voltage alarm threshold value.

R4, R5 and C5 constitutes flexible reference basic voltage circuitry, the AD signal compares with the MCU internal fixed basic voltage value, or compares to this external reference basic voltage value, since R4 and R5 can be modified, so as to obtain a different flexible reference basic voltage point.

R6 and TH1 constitutes temperature detection circuitry. If the ambient temperature varies, the TH1 resistor will be varied as well, and the preset alarm voltage threshold value will make relative compensation via program.

SW1, R10 and C8 consists of the vibration sensing circuitry, when the vibration occurred, SW sensor opens or closes and causes the voltage of PA4/ Pin15 of the MCU to be varied accordingly.

J1 connector net is a port for programming MCU firmware.

R7, R8 and R9 are LED lights connected to the pin7,Pin8 and Pin9 through the current limited resistors of R7, R8 and R9.

BZ1 is the buzzer connected to the BZ1, BZ2 / Pin4, Pin5 of MCU.

In the description provided herein, numerous specific details are set forth. However, it is understood that embodiments of the invention may be practiced without these specific details. In other instances, well-known methods, structures and techniques have not been shown in detail in order not to obscure an understanding of this description.

While the invention has been described mainly by reference to installation in an automobile, it will be understood that no limitation to that application is intended. Having the benefit of the present specification the skilled person is enabled to apply the invention to other types of vehicle and machinery that comprise a rechargeable battery to power a starter motor.

It is not represented that all embodiments of the invention have all advantages discussed herein. Indeed some embodiments may have only a single advantage. Other embodiments may provide no advantage whatsoever and merely provide a useful alternative to the prior art.

In the following claims, any of the claimed embodiments can be used in any combination.

## Claims

1. Apparatus for determining the state of a rechargeable battery used to power a starter motor of an engine, the apparatus comprising:
a voltage measurement means configured to measure a voltage value in a rechargeable battery of an engine starting circuit configured to power the starter motor,
a voltage relation means in operable connection with the voltage detector,
a user comprehensible output means,
wherein the apparatus is configured such that during powering of the starter motor the voltage measurement means measures one or more voltage values of the rechargeable battery, and the voltage relation means relates the measured one or more voltage values to a predetermined one or more voltage values so as to determine a state of the rechargeable battery, and the user comprehensible output is configured to output an indication of the state of the rechargeable battery.

2. The apparatus of claim 1, wherein the relating of voltage values comprises comparing voltage values or comparing a rate of change in voltage values.

3. The apparatus of claim 2, wherein two or more voltage values are measured, and the voltage relation means is configured to compare a low voltage value, or the lowest voltage value, of the measured two or more voltage values to the predetermined one or more voltage values.

4. The apparatus of claim 3, wherein where the low voltage value or the lowest voltage is determined by the voltage relation means to be less than the predetermined one or more voltage values, the user comprehensible output outputs a warning indicating that the rechargeable battery is in a compromised state.

5. The apparatus of any one of claims 1 to 4, wherein the predetermined voltage value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the voltage specification of the rechargeable battery.

6. The apparatus of any one of claims 1 to 5, wherein the predetermined voltage value is equal to or less than about 10V, 9.9V, 9.8V, 9.7V, 9.6V, 9.5V, 9.4V, 9.3V, 9.2V, 9.1V, 9.0V, 8.9V, 8.7V, 8.6V. 8.5V, 8.4V, 8.3V, 8.2V, 8.1V, or 8.0V.

7. The apparatus of any one of claims 1 to 6, wherein the predetermined voltage value is equal to or less than about 9.0V.

8. The apparatus of any one of claims 2 to 7, wherein where the rate of change in voltage values is determined by the voltage relation means to be greater than a predetermined rate, the user comprehensible output outputs a warning indicating that the rechargeable battery is in a compromised state.

9. The apparatus of claim 8, wherein the predetermined rate of change in voltages value is equal to or less than about 90%, 89%, 88%, 87%, 86%, 85%, 84%, 83%, 82%, 81%, 80%, 79%, 78%, 77%, 76%, 75%, 74%, 73%, 72%, 71%, 70%, 69%, 68%, 67%, 66%, 65%, 64%, 63%, 62%, 61% or 60% of the rate specification of the rechargeable battery when new.

10. The apparatus of any one of claims 1 to 9, comprising a temperature measuring means, and the apparatus is configured to utilise a measured temperature value to determine a state of the rechargeable battery.

11. The apparatus of claim 10, wherein the measured temperature value is used to calculate, interpolate, extrapolate, select, generate, modify or otherwise provide the predetermined one or more voltage values.

12. The apparatus of any one of claim 1 to 11, wherein the measured one or more voltage values and optionally the measured temperature value is/are used by a microprocessor to determine whether or not to instruct the user comprehensible output unit to output a warning that the rechargeable battery is in a compromised state.

13. The apparatus of any one of claims 1 to 12 being configured to connect to a vehicle OBD system, and/or a vehicle OBD connector; or being configured to replace a vehicle OBD connector.

14. The apparatus of any one of claims 1 to 13, wherein the voltage relation means is a microprocessor comprising or having access to electronic memory having stored thereon program instructions configured to perform any one or more of the following:
sampling one or more voltages output by the voltage measurement unit,
sampling or more temperatures output by the temperature measurement unit,
relating a predetermined voltage to sampled one or more voltages,
comparing a predetermined voltage to sampled one or more voltages.

15. The apparatus of any one of claims 1 to 14, constructed by way of a modular PCB design methodology.
